# EUROPÄISCHE PATENTSCHRIFT

(11) **EP 2 641 305 B1**
(45) Veröffentlichungstag und Bekanntmachung des Hinweises auf die Patenterteilung: **24.12.2014**
(21) Anmeldenummer: 11778577.4
(22) Anmeldetag: 28.10.2011
(51) Int. Cl.: H01S 5/183, H01S 5/028

(54) **POLARISATIONSSTABILE OBERFLÄCHENEMITTIERENDE LASERDIODE**
POLARIZATION-STABLE SURFACE-EMITTING LASER DIODE
DIODE LASER ÉMETTANT PAR LA SURFACE, À POLARISATION STABLE

(30) Priorität: 17.11.2010 DE 102010044082; 05.10.2011 DE 102011084047
(43) Veröffentlichungstag der Anmeldung: 25.09.2013
(73) Patentinhaber: Vertilas GmbH, 85748 Garching (DE)
(72) Erfinder: AMANN, Markus-Christian, 80935 München (DE); ORTSIEFER, Markus, 80939 München (DE); ROSSKOPF, Jürgen, 82515 Wolfratshausen (DE)
(74) Vertreter: Kudlek & Grunert Patentanwälte
(86) Internationale Anmeldenummer: PCT/EP2011/069062
(87) Internationale Veröffentlichungsnummer: WO 2012/065834

(56) Entgegenhaltungen:
- EP-A1- 0 820 131
- WO-A2-2007/057807
- JP-A- 2005 093 588
- US-A1- 2008 112 443
- HODGKINSON I ET AL: "BIAXIAL THIN-FILM COATED-PLATE POLARIZING BEAM SPLITTERS", APPLIED OPTICS, OPTICAL SOCIETY OF AMERICA, WASHINGTON, DC; US, Bd. 45, Nr. 7, 1. März 2006 (2006-03-01), Seiten 1563-1568, XP001239243, ISSN: 0003-6935, DOI: 10.1364/AO.45.001563

## Beschreibung

Oberflächenemittierende Laserdioden (engl. Vertical-Cavity Surface-Emitting Laser: VCSEL) werden aufgrund ihrer zahlreichen Vorzüge, wie geringe Schwellenströme und symmetrische Strahlungskeule, zunehmend in modernen optoelektronischen Systemen eingesetzt und verdrängen dabei nach und nach die herkömmlichen kantenemittierenden Halbleiterlaser. Aufgrund ihrer mehr oder weniger stark ausgeprägten transversalen Symmetrie (Rotationssymmetrie) weisen die VCSEL keine oder nur eine unzureichende Polarisationsselektivität auf. Dies kann im Betrieb zu Polarisationsinstabilitäten und Polarisationssprüngen führen, was einen Einsatz entsprechender Laser für die meisten Anwendungen ausschließt.

Oberflächenemittierende Laserdioden besitzen in der Regel eine zylindersymmetrische Struktur und weisen aufgrund ihres Designs sowie ihrer Herstellungsverfahren keine Vorzugsrichtung für die Polarisationsrichtung der abgestrahlten Welle auf. Es existieren daher zwei orthogonale Zustände bzgl. der Polarisationsrichtung der abgestrahlten Welle. In einer idealen Laserstruktur sind diese beiden Zustände energetisch entartet und für den Laserbetrieb gleichberechtigt. Aufgrund des elektrooptischen Effektes und Anisotropien im Bauelementedesign sowie Asymmetrien und Fluktuationen des Herstellungsprozesses wird diese Entartung jedoch aufgehoben und der VCSEL schwingt dominant nur auf der jeweils bevorzugten Polarisationsmode. In den meisten Fällen ist der zur Bevorzugung einer bestimmten Mode führende Mechanismus schwer kontrollierbar bzw. nicht offensichtlich und schwach ausgeprägt, womit sich insgesamt ein statistischer und instabiler Charakter des Polarisationsverhaltens ergibt. Die Polarisationssprünge limitieren generell den Einsatz in polarisationsabhängigen optischen Systemen. Beispielsweise führen solche Sprünge in der optischen Datenübertragung zu einem erhöhten Rauschen. Da viele Anwendungen auf polarisationsstabile Laser als Lichtquellen angewiesen sind, bedeutet dies eine signifikante Reduktion der Produktionsausbeute. In manchen Fällen ist zwar eine Vorzugsrichtung definierbar, doch ist die Aufhebung der Entartung nicht stark genug, um Polarisationsstabilität bei veränderlichen Umgebungs- und Betriebsbedingungen zu gewährleisten. In diesem Fall können selbst leichte Veränderungen dieser Parameter einen Wechsel zwischen den beiden Zuständen ("Polflip") bewirken.

In der Vergangenheit wurden vielfältige Lösungsmöglichkeiten zur Stabilisierung der Polarisation studiert. Für Erreichung von Polarisationsstabilität von GaAs-basierten VCSEL wurde das Wachstum auf höher indizierten [311]-Substraten erfolgreich nachgewiesen in O. Tadanaga, K. Tateno, H. Uenohara, T. Kagawa, and C. Amano, "An 850-nm InAlGaAs Strained Quantum-Well Vertical-Cavity Surface-Emitting Laser Grown on GaAs (311)B Substrate with High-Polarization Stability", IEEE Photon. Technol. Lett., 12, 942 (2000). Da sich jedoch die sonstigen Lasereigenschaften in der Regel verschlechtern und insbesondere für InP-basierte Halbleiterschichten schwierige Wachstumsbedingungen bestehen, erscheint diese Methode für langwellige VCSEL nicht geeignet.

Ein weiterer Lösungsansatz besteht in der Verwendung von dielektrischen oder metallischen Gitterstrukturen wie in J.-H. Ser et al., "Polarisation stabilisation of vertical-cavity top-surface-emitting lasers by inscription of fine metal-interlaced gratings", Appl. Phys. Lett. 66, 2769 (1995); T. Mukaihara et al., "Polarization control of vertical-cavity surface-emitting lasers using a birefringent metal/dielectric polarizer loaded on top distributed Bragg Reflector", IEEE J. Sel. Top. Quantum. Electron. 1, 667 (1995); M. Ortsiefer et al., "Polarization Control in Buried Tunnel Junction VCSELs Using a Birefringent Semiconductor/Dielectric Subwavelength Grating", IEEE Photon. Technol. Lett., 22, 15 (2010) und P. Debernardi et al.: "Reliable Polarization Control of VCSELs Through Monolithically Integrated Surface Gratings: A Comparative Theoretical and Experimental Study", IEEE J. Sel. Top. Quantum Electron. 11, 107 (2005) gezeigt. Dabei dienen metallisch-dielektrische Gitter mit Subwellenlängenabmessungen zur Erzeugung von Doppelbrechung im Laserresonator. Damit kann die optische Resonatorlänge, bzw. die Resonanzfrequenz des Laserresonators, nur bei einer Polarisation mit dem Maximum des bzw. der Braggspiegel übereinstimmen. Die andere Polarisation wird damit unterdrückt. Die vorgestellten dielektrischen Gitter hingegen nutzen Interferenzeffekte im Gitter aus, wodurch die Gesamtreflexion polarisationsabhängig durch das Gitter verstärkt oder abgeschwächt wird. Die Periode der entsprechenden Gitterstrukturen sollte daher nicht unter ca. einer halben Vakuumwellenlänge liegen. Ein Lösungsansatz für die von der Anmelderin hergestellten BTJ (Buried-Tunnel-Junction) - VCSEL mit integrierten Subwellenlängengittern kleiner Periode (<λ/2) wurde kürzlich vorgestellt von M. Ortsiefer et al., "Polarization Control in Buried Tunnel Junction VCSELs Using a Birefringent Semiconductor/Dielectric Subwavelength Grating", IEEE Photon. Technol. Lett., 22, 15 (2010). Generell ist die Technologie der Subwellenlängengitter, insbesondere wenn diese mit anderen Dielektrika aufgefüllt werden müssen, kompliziert und aufwendig (Nanostrukturierung), wenngleich die Vorteile eindeutig sind.

Die JP 2005-093858 A beschreibt einen VCSEL mit einer doppelbrechenden Schicht außen an einem Spiegel des Resonators. Dies führt zu einer Vorzugsrichtung der Polarisation, jedoch auch zu einer Reduktion der Gesamtreflexion.

In der US 2008/112443 A1 wird ein VECSEL mit einem externen Resonatorspiegel. Innerhalb des Resonators ist eine polarisationsselektive Schicht angeordnet. In der WO 2007/057807 A2 der Philips Forschungslaboratorien wurde 2005 vorgeschlagen, innerhalb des VCSEL-Resonators vor einem der beiden Endspiegel eine Schicht mit polarisationsabhängigem Brechungsindex oder polarisationsabhängiger Absorption einzufügen, sodass die effektive Spiegelreflexion polarisationsabhängig wird und damit eine Polarisationsmode bevorzugt wird und anschwingt. Ein entscheidender Nachteil dieser Methode sowie aller Verfahren, die polarisationsselektive Elemente innerhalb des Laserresonators einbringen, ist die gleichzeitige Beeinflussung der (optischen) Resonatorlänge und damit der Laserwellenlänge. Auch können Verluste in den anisotropen Schichten vorliegen, insbesondere bei schräg aufgedampften, die die Lasereigenschaften (z.B. die Schwelle) empfindlich verschlechtern können. Zudem ergibt sich eine kompliziertere Herstelltechnologie und eine reduzierte Ausbeute, wenn die Laserwellenlänge genau getroffen werden muss.

Aufgabe vorliegender Erfindung ist es, die genannten Nachteile im Stand der Technik zu überwinden, insbesondere eine polarisationsstabile oberflächenemittierende Laserdiode anzugeben, die mit einer weniger komplizierten Herstelltechnologie auskommt.

Die vorliegende Erfindung löst das Problem der Polarisationsselektion- und -stabilisierung in VCSELn dadurch, dass mit einer vergleichsweise einfachen und effektiven Technologie optische Doppelbrechung in einem dielektrischen Laserspiegel erzeugt wird und dadurch eine polarisationsabhängige Reflektivität entsteht, die eine der beiden in-plane Polarisationen bevorzugt. Dazu werden im Gegensatz zu der bekannten Anordnung in Druckschrift WO 2007/057807 A2 mehrere Schichten mit polarisationsabhängiger Brechzahl außerhalb eines oder beider Laserspiegel angebracht. Die erfindungsgemäße oberflächenemittierende Laserdiode weist einen aktiven, verstärkenden Bereich auf, der von zwei Laserspiegeln begrenzt wird, wobei zur Polarisationsstabilisierung in einem Bereich, der sich auf der dem aktiven, verstärkenden Bereich gegenüberliegenden Seite zumindest eines der Laserspiegel befindet, mehrere polarisationsselektive Schichten vorhanden sind, die parallel zum jeweiligen Spiegel verlaufen und eine polarisationsabhängige Brechzahl und/oder Absorption aufweisen. Damit kann gewährleistet werden, dass die Laserwellenlänge unabhängig von der Polarisationsstabilisierung eingestellt werden kann und Verluste in den Schichten kaum Auswirkungen auf die Laserschwelle haben. Die Herstellung und das Aufbringen der polarisationsabhängigen Schichten auf die Laserspiegel kann relativ einfach mittels Schrägaufdampfens von Dielektrika, z. B. Silizium, erfolgen.

Die vorliegende Erfindung präsentiert somit einen Lösungsvorschlag für polarisationsstabile oberflächenemittierende Laserdioden. Die Idee beruht auf der Verwendung eines optisch anisotropen dielektrischen Spiegels, der aufgrund der polarisationsabhängigen Brechzahl der Schichten in Abhängigkeit der Polarisationsrichtung unterschiedliche Reflektivität aufweist. Die Anisotropie wird z. B. durch schräges Aufdampfen einer oder mehrerer dielektrischer Schichten des Spiegels erzeugt. Die erfindungsgemäße Spiegelstruktur ermöglicht ein deterministisches und stabiles Polarisationsverhalten bei hoher Polarisationsmoden-Seitenmodenunterdrückung sowie Unempfindlichkeit der Polarisation gegenüber Rückkopplung.

Es ist für das Herstellungsverfahren vorteilhaft, wenn eine polarisationsselektive Schicht direkt auf einen der Laserspiegel aufgebracht ist.

Insbesondere sind mehrere polarisationsselektive Schichten auf der Außenseite eines Laserspiegels vorhanden, die jeweils abwechselnd bezüglich ihrer Polarisationsausrichtung um 90° verdreht sind und deren Reflektionsphase derjenigen des Laserspiegels, auf dessen Seite sie sich befinden, für die eine Polarisation gleich und für die andere Polarisation entgegengesetzt ist. Besonders vorteilhaft ist es dabei, die Schichtdicken jeweils entsprechend einem Viertel der Laserwellenlänge in der bevorzugten Polarisation zu wählen. Nähere Erläuterungen zu einem solchen Aufbau und seinen Vorteilen finden sich weiter unten bei den Ausführungsbeispielen.

Es ist weiterhin vorteilhaft, wenn den mehreren polarisationsselektiven Schichten auf der den jeweiligen Laserspiegel abgewandten Seite eine isotrope Schicht folgt, die insbesondere aus Aluminiumoxid oder Siliziumnitrid besteht, wobei weiterhin insbesondere die Dicke diese isotropen Schicht einer halben Wellenlänge des Laserlichts in dieser Schicht entspricht. Nähere Erläuterungen zum Aufbau und zu den Vorteilen dieser Ausgestaltung finden sich ebenfalls in den Ausführungsbeispielen.

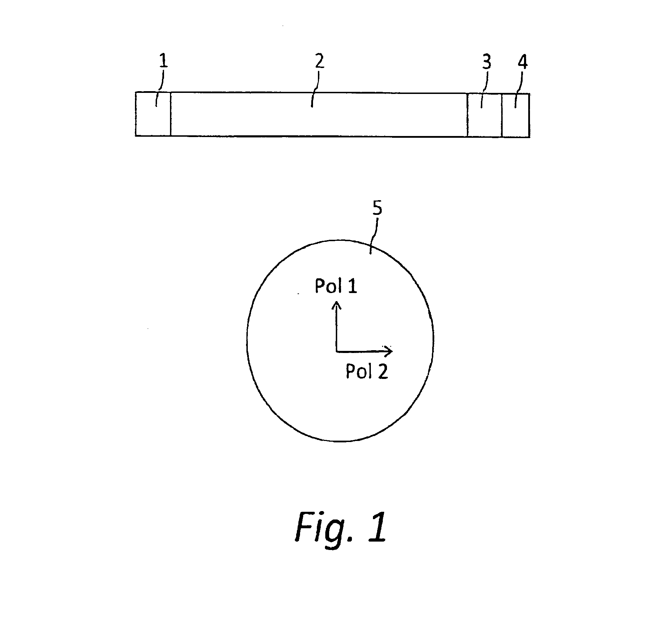

Die Erfindung und ihre Vorteile werden nunmehr anhand von Ausführungsbeispielen näher erläutert.
- Figur 1: zeigt eine erste Ausführungsform eines erfindungsgemäßen Aufbaus einer oberflächenemittierenden Laserdiode,
- Figur 2: zeigt eine typische Anordnung eines schematischen Längsschnitts durch eine Laserdiode gemäß Stand der Technik sowie das zugehörige Brechzahlprofil,
- Figur 3: zeigt einen Teil eines Längsschnitts gemäß Stand der Technik in schematischer Ansicht zusammen mit den den Schichten zugeordneten Brechzahlen,
- Figur 4: zeigt die Transmission ("1-Rmax(%)") als gestrichelte Linie in Abhängigkeit von der Dicke der Schicht in Mikrometer ("thickness (microns)") sowie die Differenz der Reflektivitäten ("Delta-R(%)*5") der beiden Polarisationen als durchgezogene Linie (mit dem Faktor 5 multipliziert), ebenfalls abhängig von der Schichtdicke der Siliziumschicht; sowohl die Transmissionskurve als auch die Differenzkurve der Reflektivitäten sind in Prozent aufgetragen,
- Figur 5: zeigt eine Ausführungsform eines Aufbaus einer erfindungsgemäßen oberflächenemittierenden Laserdiode in schematischem Längsschnitt mit zwei polarisationsselektiven Schichten sowie das zugehörige Brechzahlprofil für die beiden Polarisationen,
- Figur 6: zeigt eine Darstellung entsprechend Figur 4 für einen Aufbau gemäß Figur 5 mit zwei polarisationsselektiven Schichten aufgetragen gegen eine für beide Schichten identische Einzelschichtdicke und
- Figur 7: zeigt weitere Ausführungsformen eines schematisch dargestellten erfindungsgemäßen Aufbaus einer oberflächenemittierenden Laserdiode.
Eine mögliche Ausführungsform der Erfindung ist in Fig. 1 gezeigt. Oben ist ein schematischer Längsschnitt durch einen erfindungsgemäßen Laser gezeigt. Dieser besteht aus dem aktiven, verstärkenden Bereich 2, der von zwei Spiegeln 1 und 3 begrenzt wird und dessen Resonatorlänge, und damit die Laserwellenlänge, von diesen bestimmt wird. Die erfindungsgemäße Polarisationsstabilisierung wird durch die zusätzlich außen auf einen (oder beide) Spiegel 3 aufgebrachte Schichtenfolge 4 geleistet. Diese Schichtenfolge kann aus mehreren Schichten bestehen, von denen zumindest eine polarisationsabhängige Brechzahl oder Absorption aufweist. Unten in Fig. 1 ist der Laserquerschnitt 5 schematisch gezeigt, der rotationssymmetrisch oder elliptisch ist. Die Richtungen der beiden senkrecht zueinander stehenden Polarisationen Pol 1 und Pol 2 sind durch zwei Vektoren illustriert. Die Spiegel 1 und 3 bestehen gewöhnlich aus zahlreichen Paaren von dielektrischen Schichten unterschiedlicher Brechzahl. Das Laserlicht wird an jeder Schichtgrenzfläche reflektiert, so dass sich eine entsprechend hohe Gesamtreflexion von typischerweise über 99% ergibt.

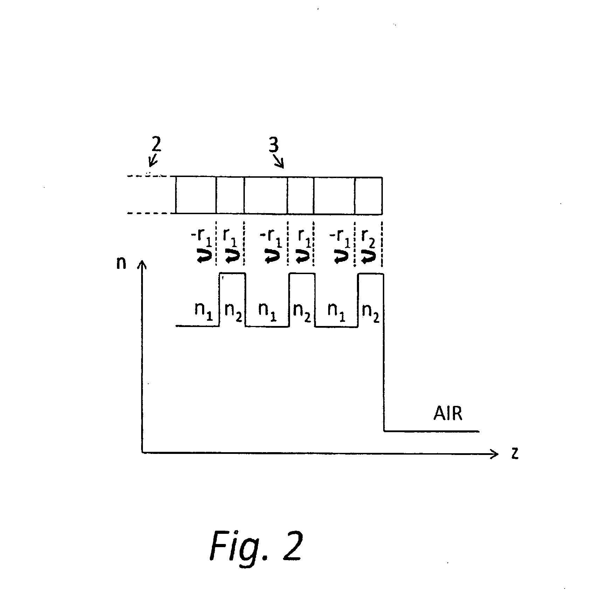

Eine typische Anordnung nach Stand der Technik ohne die Schichten 4 ist in Fig. 2 gezeigt. Die einzelnen Reflexionen r1 und - r1 addieren sich phasenrichtig mit der Endreflexion r2 gegen den Aussenbereich "AIR" (Luft). Da die Brechzahlen n1 und n2 der Spiegelpaare polarisationsunabhängig sind, dh. keine Doppelbrechung aufweisen, ist die Gesamtreflektivität, die der aus dem Laserresonator 2 kommende Lichtstrahl erfährt, polarisationsunabhängig.

Die erfindungsgemäße Laserstruktur erzeugt mit einer auf der Außenseite des Spiegels 3 aufgebrachten Schichtfolge 4 eine polarisationsabhängige Gesamtreflektion für das aus dem Resonator 2 kommende Licht und stabilisiert die Laserpolarisation, da der Laser dann in derjenigen Polarisation emittiert, die die höhere Gesamtreflexion aufweist.

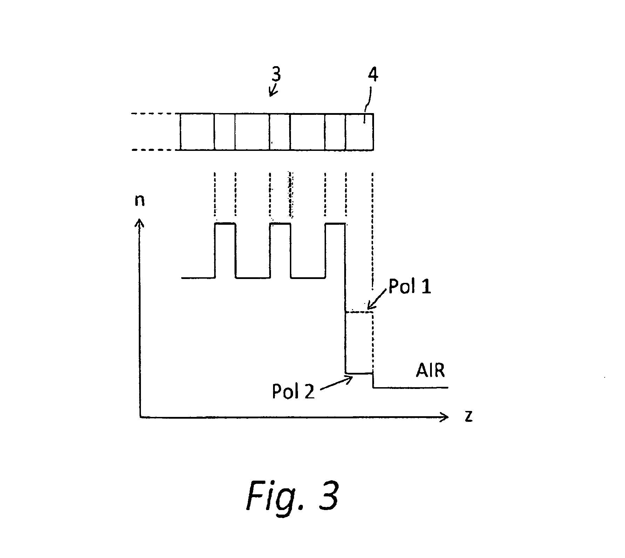

Ein Beispiel mit nur einer Schicht 4 ist in Fig. 3 gezeigt. Die Brechzahlen n in der Schicht 4 für die beiden Polarisationen (Pol 1, Pol 2) sind mit durchgezogenen bzw. gestrichelten Linien markiert. Aufgrund der unterschiedlichen Brechzahlen ergeben sich unterschiedliche bzw. polarisationsabhängige Reflexionsfaktoren an den Grenzflächen der Schicht 4. Zusammen mit der Reflexion des Spiegels 3 entsteht dadurch eine polarisationsabhängige Gesamtreflektivität an der Grenzfläche zum Resonator 2. Rechnungen zeigen, dass ein Unterschied in der Gesamtreflektivität von mindestens 0.01%, bevorzugt mindestens 0.1%, notwendig ist, um die Laserleistung stabil in nur einer Polarisation zu emittieren.

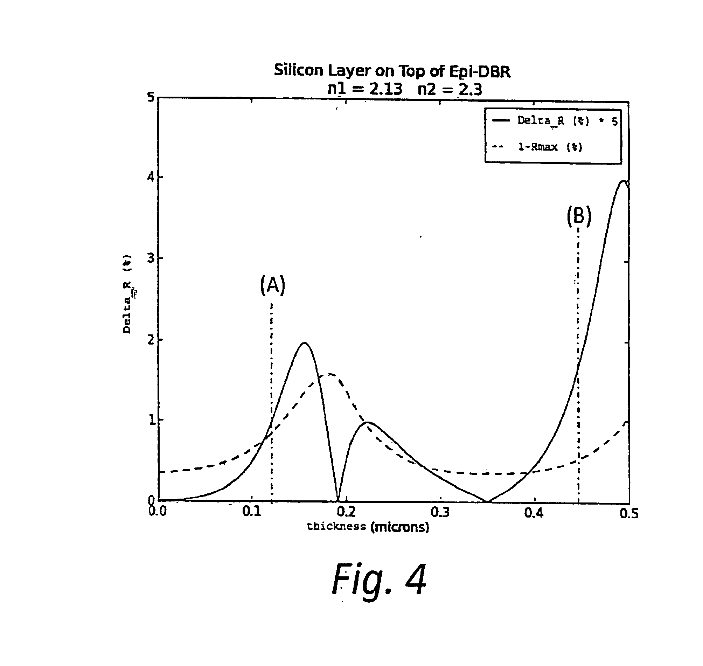

Fig. 4 zeigt eine Berechnung einer Laserstruktur für eine Wellenlänge von 1.55µm beschichtet mit einer Siliziumschicht variabler Dicke, die unter einem Winkel von 60° schräg aufgedampft wurde ("Silicon Laser on Top of Epi-DBR", deutsch: Siliziumschicht auf Epi-DBR (=Spiegel)). Die Brechzahlen dieses schräg aufgedampften Siliziums bei der Laserwellenlänge wurden experimentell für die beiden Polarisationen zu ca. 2.13 (n1) beziehungsweise 2.3 (n2) bestimmt. Die Gesamtreflektivität des Spiegels 3 beträgt ohne Schicht 4 ca. 99.6%. Die Grafik zeigt gestrichelt die Transmission, d. h. die Differenz der Gesamtreflektivität zu 100%, und durchgezogen die Differenz der Reflektivitäten der beiden Polarisationen. Zur besseren Veranschaulichung wurde die Differenzreflektivität mit dem Faktor fünf multipliziert. Wie man sieht, kann leicht eine Differenz der Reflektivitäten von 0.2% bei einer Dicke der Si-Schicht von 120nm (A) oder sogar 0.6% bei 450nm (B) erzielt werden. Im Gegensatz zu Anordnungen mit der polarsisationsselektiven Schicht innerhalb des Resonators ( WO 2007/057807 A2) bleibt die Wellenlänge des Lasers unabhängig von der Dicke der Schicht 4 praktisch konstant. Wie ebenfalls aus der Fig. 4 zu ersehen ist, geht die Polarsiationsselektivität mit einer erhöhten Transmission einher, was eine verringerte Gesamtreflexion bedeutet und letztlich zu einer höheren Laserschwelle führt. Auch weist die Anordnung in Fig. 3, insbesondere auch an den Punkten (A) und (B), eine ausgeprägte Abhängigkeit der Gesamtreflexion von der Si-Schichtdicke auf (siehe Fig. 4), wodurch Parameterschwankungen beim Herstellungsprozess die Laserausbeute verringern könnten. Deshalb wäre eine Anordnung, die eine polarisationsabhängige Reflektivität ohne Reduktion der Gesamtreflexion bewirkt, vorzuziehen.

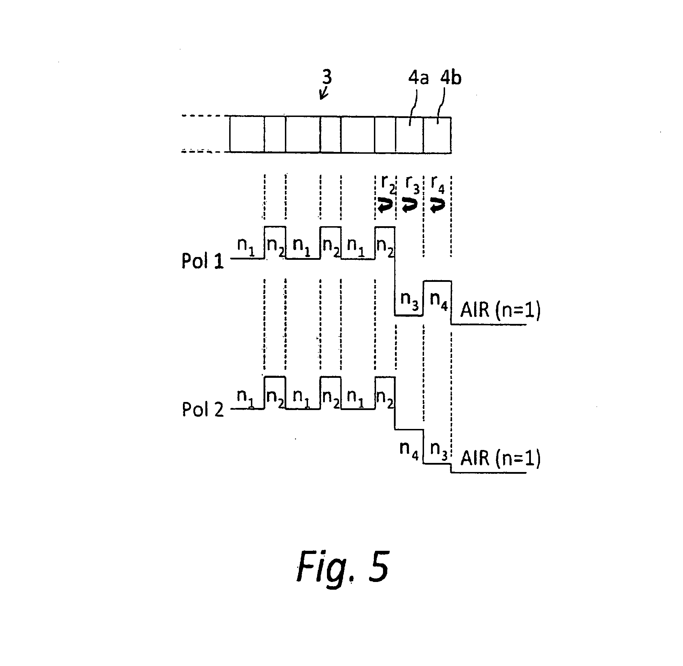

Eine weitere Ausführungsform der Erfindung, die diesen Nachteil nicht aufweist, indem sie eine polarisationsselektive Gesamtreflexion ohne Erniedrigung der Gesamtreflexion ermöglicht, kann durch Aufbringen von mehreren polarisationsselektiven Schichten erreicht werden, wenn diese jeweils abwechselnd bezüglich ihrer Polarisationsausrichtung um 90° verdreht sind und ihre Reflexionsphase derjenigen des Laserspiegels 3, auf dessen Seite sie sich befinden, für die eine Polarisation gleich und für die andere Polarisation entgegengesetzt ist. Praktisch lässt sich dies sehr einfach bei einer Aufdampfung dadurch realisieren, dass die Richtung, aus der die schräge Aufdampfung mit einem Anstellwinkel von typisch 60° erfolgt, nach jeder Schicht um 90° verdreht wird. Man dreht dabei die zu bedampfenden Laser jeweils nach jeder Schicht abwechselnd 90° um ihre Achse. Das resultierende polarisationsabhängige Brechzahlprofil ist in Fig. 5 gezeigt.

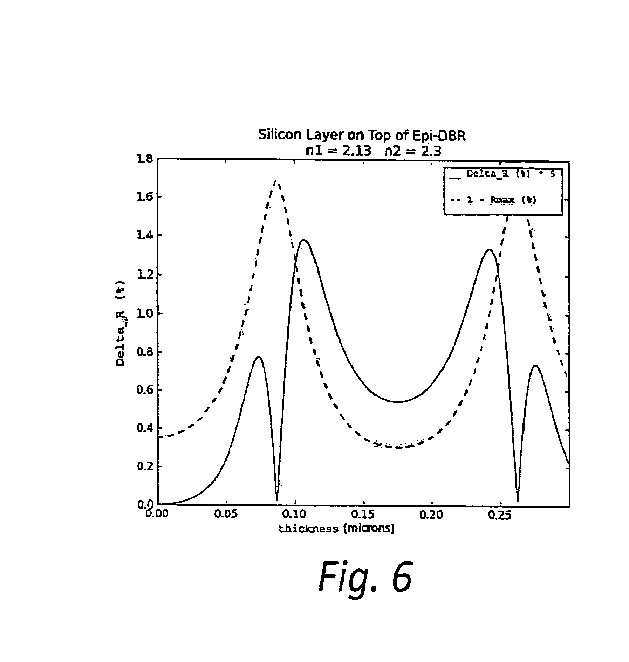

In dieser Anordnung sind die Dicken der Schichten 4a und 4b vorzugsweise ein Viertel der Laserwellenlänge dividiert durch die jeweilige Brechzahl n3 und n4. Damit ergeben sich für die Polarisation Pol 1 konstruktive Reflexionen r3 und r4 bezogen auf die Reflexion des Spiegels 3, die die Gesamtreflexion des Spiegels 3 sogar noch etwas erhöhen. Andererseits ist die Reflexion r3 für die andere Polarisation Pol 2 destruktiv, da für diese Polarisation die Schicht 4b mit n3 eine kleinere Brechzahl als die Schicht 4a mit n4 aufweist. Eine entsprechende Rechnung für einen Laser bei 1.55µm beschichtet mit zwei um 90° verdrehten, schräg (60°) aufgedampften Si-Schichten zeigt Fig. 6.

Wie in Figur 6 gut zu erkennen ist, ergibt sich bei ca. 175nm Dicke jeweils beider Schichten, entsprechend ca. einem Viertel der Wellenlänge, eine Differenz der Reflektivitäten der beiden Polarisationen von ca. 0.1%, während die Transmission bzw. die Gesamtreflexion praktisch konstant bleibt. Ein zusätzlicher Vorteil der einschichtigen Anordnung in Fig. 3 ist die große Prozesstoleranz bezüglich der Dicke der aufgedampften Schichten. Eine Schichtdicke zwischen 150nm und 200nm ergibt im Wesentlichen denselben Effekt auf Polarisationsselektion und Gesamtreflektivität.

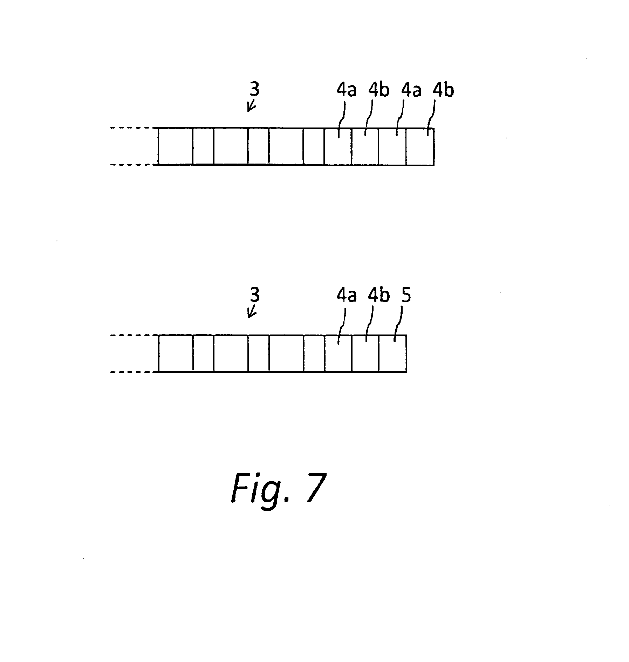

Weitere Ausführungsformen der Erfindung, die noch bessere Eigenschaften aufweisen können, sind in Fig. 7 gezeigt. Oben in der Zeichnung ist gezeigt, dass die Schichtenfolge 4 aus mehr als nur einem jeweils um 90° gedrehten Schichtpaaren mit anisotropen Dielektrika bestehen kann. Dadurch ergibt sich im Vergleich zu Fig. 6 eine ca. mit der Anzahl der Paare proportional zunehmende Differenz der polarisationsabhängigen Reflektivität und damit auch eine entsprechend stärkere Polarisationsstabilisierung. Unten in Fig. 7 ist gezeigt, dass die Schichtenfolge 4 mit zusätzlichen isotropen Schichten 5 abgedeckt werden kann. Dabei kann beispielsweise eine Erosion der anisotropen Schichten 4 durch die Umgebungsluft durch eine dichte, senkrecht aufgedampfte Schutzschicht aus Aluminiumoxid oder Siliziumnitrid verhindert werden. Wenn die Dicke dieser Schutzschicht einer halben Wellenlänge des Laserlichts in der Schutzschicht entspricht, hat diese keinen Einfluss auf die Gesamtreflexion der Schichten 3 und 4.

Entscheidend für die Funktion der vorliegenden Erfindung ist die Herstellung einer ausreichend doppelbrechenden (anisotropen) dielektrischen Schicht. In der vorliegenden Erfindung wird dies einfach und effektiv und ohne aufwendige Nanotechnologie durch schräges Aufdampfen der betreffenden Schicht(en) erzielt. Gemäß T. Motohiro und Y. Taga, "Thin film retardation plate by oblique deposition", Applied Optics, 28, 2466 (1989) und I. Hodgkinson und Q. Wu, "Serial bideposition of anisotropic thin films with enhanced linear birefringence", Applied Optics, 38, 3621 (1999) entstehen bei diesem Verfahren selbst-organisiserte Nanostrukturen in der Schicht (den Schichten), die zu einer Form-Anisotropie führen und die typisch einen Unterschied der Brechzahlen der beiden in-plane (d.h. parallel zur Scheibenoberfläche) Polarisationen von bis zu 5-10% ergeben. Besonders hohe Anisotropie lässt sich mit Siliziumschichten erzielen, die um 60° geneigt zur Oberflächennormale auf die Laserspiegel aufgedampft werden, wie in G. Beydaghyan et al.: "Enhanced birefringence in vacuum evaporated silicon thin films", Appl. Opt. 43, 5343 (2004) gezeigt. Die Erfindung beschränkt sich jedoch nicht nur auf diesen Herstellprozess. Jede andere Technik zum Aufbringen von anisotropen dielektrischen Schichten ist grundsätzlich geeignet.

Die erfindungsgemäße Struktur kann insbesondere auf BTJ-VCSEL in verschiedenen Materialsystemen angewendet werden. Hierzu zählen GaAs-, InP- bzw. GaSb-basierte Bauelemente.

### Bezugszeichenliste

- 1: Spiegel
- 2: aktiver, verstärkender Bereich, Resonator
- 3: Spiegel
- 4, 4a, 4b: polarisationsselektive Schicht
- 5: Laserquerschnitt

- n1, n2, n3, n4: Brechzahl
- r1, r2, r3, r4: Reflektivität
- Pol1, Pol2: Polarisationsrichtung

## Patentansprüche

1. Oberflächenemittierende Laserdiode mit einem aktiven, verstärkenden Bereich (2) mit einer Resonatorlänge, wobei der aktive, verstärkende Bereich (2) von zwei Laserspiegeln (1, 3) begrenzt wird, die die Resonatorlänge bestimmen, wobei zur Polarisationsstabilisierung in einem Bereich, der sich auf der dem aktiven, verstärkenden Bereich (2) gegenüberliegenden Seite zumindest eines der Laserspiegel (1, 3) befindet, mehrere polarisationsselektive Schichten (4a, 4b) vorhanden sind, die parallel zum jeweiligen Spiegel (1; 3) verlaufen und eine polarisationsabhängige Brechzahl aufweisen,
wobei die mehreren polarisationsselektiven Schichten (4a, 4b) jeweils abwechselnd bezüglich ihrer Polarisationsausrichtung um 90° verdreht sind und deren Reflexionsphase derjenigen des Laserspiegels (3), auf dessen Seite sie sich befinden, für die eine Polarisation gleich und für die andere Polarisation entgegengesetzt ist.

2. Oberflächenemittierende Laserdiode nach Anspruch 1, **dadurch gekennzeichnet, dass** eine polarisationsselektive Schicht (4) direkt auf einen der Spiegel (1; 3) aufgebracht ist.

3. Oberflächenemittierende Laserdiode nach einem der Ansprüche 1 bis 2, wobei den mehreren polarisationsselektiven Schichten (4a, 4b) auf der dem jeweiligen Laserspiegel (1; 3) abgewandten Seite eine isotrope Schicht (5) folgt, die insbesondere aus Aluminiumoxid oder Siliziumnitrid besteht, wobei weiterhin insbesondere die Dicke dieser Schicht (5) einer halben Wellenlänge des Laserlichts in dieser Schicht (5) entspricht.

4. Oberflächenemittierende Laserdiode nach einem der Ansprüche 1 bis 3, wobei die mehreren polarisationsselektiven Schichten (4a; 4b) jeweils aus einem Dielektrikum, wie Silizium, bestehen und insbesondere durch Schrägaufdampfen auf einen Laserspiegel (1; 3) hergestellt sind.

## Claims

1. Surface-emitting laser diode with an active amplifying region (2) having a resonator length, wherein the active amplifying region (2) is bounded by two laser mirrors (1, 3) that determine the resonator length, while a plurality of polarisation-selective layers (4a, 4b) is provided for stabilising the polarisation in a region that is located on that side of at least one of the laser mirrors (1, 3) that is opposite the active amplifying region (2), these layers (4) extending parallel to the respective mirror (1; 3) and having a polarisation-dependent refractive index,
the plurality of polarisation-selective layers (4a, 4b) each being alternately rotated through 90° relative to their polarisation alignment and the reflection phase of each of the plurality of polarisation-selective layers (4a, 4b) being the same as the reflection phase of the laser mirror (3) on the side of which the plurality of polarisation-selective layers is located for one polarisation, and the reflection phase of each of the plurality of polarisation-selective layers (4a, 4b) being opposite of the reflection phase of the laser mirror (3) for the other polarisation.

2. Surface-emitting laser diode according to claim 1, **characterised in that** a polarisation-selective layer (4) is applied directly to one of the mirrors (1; 3).

3. Surface-emitting laser diode according to one of claims 1 to 2, wherein the plurality of polarisation-selective layers (4a, 4b) on the side remote from the respective laser mirror (1; 3) is or are followed by an isotropic layer (5) consisting in particular of aluminium oxide or silicon nitride, while additionally the thickness of this layer (5) in particular corresponds to half the wavelength of the laser light in this layer (5).

4. Surface-emitting laser diode according to one of claims 1 to 3, wherein the plurality of polarisation-selective layers (4a; 4b) each consists of a dielectric such as silicon and is produced in particular by oblique angle vapour deposition onto a laser mirror (1; 3).

## Revendications

1. Diode laser émettant par la surface avec une région d'amplification active (2) ayant une longueur de résonateur, dans laquelle la région d'amplification active (2) est délimitée par deux miroirs laser (1, 3) qui déterminent la longueur de résonateur, une pluralité de couches à polarisation sélective (4a, 4b) étant prévues pour stabiliser la polarisation dans une région qui est située sur le côté d'au moins un des miroirs laser (1, 3) qui est opposé à la région d'amplification active (2), ces couches (4) s'étendant parallèlement au miroir (1 ; 3) respectif et ayant un indice de réfraction dépendant de la polarisation, chaque couche de la pluralité de couches à polarisation sélective (4a, 4b) étant alternativement tournée de 90° par rapport à son alignement de polarisation et la phase de réflexion de chacune couche de la pluralité de couches à polarisation sélective (4a, 4b) étant la même que la phase de réflexion du miroir laser (3) sur le côté duquel se situe la pluralité de couches à polarisation sélective pour une polarisation, et la phase de réflexion de chaque couche de la pluralité de couches à polarisation sélective (4a, 4b) étant opposée à la phase de réflexion du miroir laser (3) pour l'autre polarisation.

2. Diode laser émettant par la surface selon la revendication 1, **caractérisée en ce qu'**une couche à polarisation sélective (3) est directement appliquée à l'un des miroirs (1 ; 3).

3. Diode laser émettant par la surface selon l'une des revendications 1 à 2, dans laquelle la pluralité de couches à polarisation sélective (4a, 4b) sur le côté éloigné du miroir laser (1 ; 3) respectif est suivie d'une couche isotrope (5) en particulier constituée d'oxyde d'aluminium ou de nitrure de silicium, l'épaisseur de cette couche (5) correspondant de plus en particulier à une demie longueur d'onde de la lumière laser dans cette couche (5).

4. Diode laser émettant par la surface selon l'une des revendications 1 à 3, dans laquelle chaque couche de la pluralité de couches à polarisation sélective (4a ; 4b) est constituée d'un diélectrique tel du silicium et est produite par dépôt oblique en phase vapeur sur un miroir laser (1 ; 3).
